# EUROPEAN PATENT SPECIFICATION

(11) **EP 1 658 577 B1**
(45) Date of publication and mention of the grant of the patent: **11.02.2009**
(21) Application number: 04718466.8
(22) Date of filing: 08.03.2004
(51) Int. Cl.: G06K 7/10, G06K 19/07, G01S 17/74, G07C 9/00, H01L 31/04

(54) **A SYSTEM FOR IDENTIFICATION USING A TRANSPONDER POWERED BY SOLAR CELLS**
SYSTEM ZUR IDENTIFIKATION MIT EINEM DURCH SOLARZELLEN VERSORGTEN TRANSPONDER
SYSTEME D'IDENTIFICATION UTILISANT UN TRANSPONDEUR ALIMENTE PAR DES PILES SOLAIRES

(30) Priority: 10.03.2003 SE 0300631; 10.03.2003 SE 0300632; 19.05.2003 SE 0301428; 11.08.2003 SE 0302191
(43) Date of publication of application: 24.05.2006
(73) Proprietor: Scirocco AB, 192 07 Sollentuna (SE)
(72) Inventor: GUNNARSSON, Staffan, S-192 07 Sollentuna (SE)
(74) Representative: Örtenblad, Bertil Tore
(86) International application number: PCT/SE2004/000326
(87) International publication number: WO 2004/081849

(56) References cited:
- EP-A1- 0 246 374
- EP-A1- 1 043 686
- DE-C1- 4 333 426
- US-A- 4 325 146
- US-A- 4 427 839
- US-A- 4 742 573
- US-A- 5 475 381
- US-B2- 6 452 090
- DATABASE WPI Week 199430, Derwent Publications Ltd., London, GB; Class P81, AN 1994-243240, XP002903659 & JP 6 175 128 A (FUJF)FUJI PHOTO FILMS CO LTD) 24 June 1994

## Description

### BACKGROUND OF THE INVENTION

Automatic identification with electronic tags is since many years a growing market that improves the efficiency, security and convenience in many places of society. Long-range identification systems are needed for frequent identification of large and valuable objects such as cars, trucks, buses, trains, containers, manufacturing objects and even humans.

With a long range tag in the windscreen and a reader at the access point, a car can conveniently pass a parking barrier or garage door without need to open the side window and stretch out a tag. Likewise, a truck can conveniently enter or exit a factory, a distribution depot or a trailer swapping area and be safely registered. In combination with a weighing bridge at the entry and exit of a garbage dump, a concrete factory, or any other place where bulk material is handled, the net weight of the load can automatically be determined by registering the identity and weight difference between entry and exit of a vehicle. Automatic factories with readers at work cells and ID tags on the manufacturing objects experience high flexibility and low capital tie-up. ID tags can also be used to combine wide-area logistics with factory automation, e.g. to synchronize the main line of a car factory with specialized factories for car seats, dashboards and engines.

RFID (Radio Frequency Identification) tags at UHF and higher bands provide directional reading at several meters, and are often used in the above described applications. Long range RFID however needs a battery in the ID-tag, which not only is a functional problem but also an environmental threat when the tags stop working and need to be scrapped and replaced. RFID with batteryless tags requires strong emission and is only allowed at restricted UHF bands where directional antennas are both bulky and expensive.

A recent and growing problem with RFID is the explosive growth of radio based communication applications, such as radio LAN and Bluetooth, that tend to interfere with the systems and make installations with high frequency RFID tags both unreliable and vulnerable to sabotage via radio.

Another recent and major problem with long range RFID technology is that the vehicle windows ever more often are coated with a heat protecting metal film that also blocks the radio signals, a situation where reading an RFID tag through the vehicle window becomes virtually impossible.

Several attempts have been made to solve the above problems with batteryless optical ID tags, beginning already in thy early days of RFID.

One example is given by the patent US 4,742,573 from 1988 that describes an identifying card that includes electronic circuitry which enables the card to optically receive information from the reader and optically transmit information to the reader, where the card is powered by optical radiation from reader. The card includes a radiation modulating element that receives unmodulated radiation, encodes information onto the radiation under control of a microprocessor, and retransmits the radiation back to the reader. The modulating element is a semiconductor device in which incident radiation is multiply reflected within a layer of semiconductor material. This invention has been unsuccessful because of insufficient performance compared to RFID, and because of too low tolerance to interference from surrounding light. The claims are delimited against this document.

Instead of actively transmitting signals in different directions so that the card can be conveniently oriented and still be read, US 4,742,573 reflects the incident radiation. Orientation then becomes very critical, just like with a mirror that is to reflect a light beam to a specific point.

Nor does US 4,742,573 define an interference-tolerant modulation scheme for the reflected signals. Modulated light such as that from fluorescent lamps, will therefore easily disturb its receiver and reduce the maximum reading distance of the card.

Furthermore, since the reflection signal wavelength in US 4,742,573 is the same as the wavelength of the reader radiation signal, even small light leakage from a reader into its receiver will drown the weak reflected signal from the tag and impede the maximum tag reading distance.

For said reasons, US 4,742,573 would need a solar cell of a type that is extremely sensitive to weak infrared light to function properly. Such a solar cell is not defined in US 4,742,573.

US 5,475,381 describes an IR communication system for transmitting a digital bit stream at greater than 30,000 bits per second by telemetry, such as between battery operated hand-held devices and a host computer system, while the invention relates to a transponder system without batteries.

US 4,325,146 shows a transponder system for identification of objects. A radiation detector is mounted behind a glass window. The detector assembly is also mounted behind a fresnel lens. The filter characteristics plus the spectral response or the detector itself will assure that the system will be sensitive to infrared wavelengths and relatively insensitive to radiation at other wavelengths. US 4,325,146 further relates to a system with an interrogator that emits pulses from a flashtube for producing an abrupt, high magnitude, optical signal to activate the transponder.

JP 6175128 describes projector with a solar cell (30) which is powered by a halogen lamp 24 where the infrared light from the halogen lamp is reflected towards a solar cell for gaining power.

EP 0 246 374 describes a transponder system with proximity data transfer. It is possible to modulate the light from LED:s on the terminal with repetitive pulses to make the emitter on the card emit light with a specific frequency, where in such system communication of information to the transponder however is made with light pulses from the reader where clock pulses are represented by short pulses of extra intensity.

US 6,452,090, US 4,427,839 and DE 4333426 all describe examples of solar cells with different characteristics, for example using monocrystalline silicon and using passivization against recombination effects, such examples however not describing the use of such solar cells in a transponder.

Many years after that the first optical identification transponder system was invented, still no batteryless tag system has been brought forward that suits the described applications. The object of this invention is therefore to present a beam powered system that is based on a new combination of technologies, that in their normal use are well known but that in combination forms a new batteryless transponder system fo long range identification that has both excellent performance and strong robustness to interference from all commonly used light sources.

The invention also unexpectedly solves the new and major problems with radio interference and signal blocking that RFID is facing in many of the applications where the invention is to be used.

By using essentially infrared waves instead of radio waves, the invention makes possible a compact system that only has a fraction of the cost compared to a long range RFID system, that offers directed reading at four meters distance, that provides safe function both in dark and strongly lit environments and that makes possible invisible remote powering of the transponders.

The invention therefore challenges any imagination that long range identification systems need to be expensive ad have large antennae and/or that batteryless optical transponders have short range, need irritating light for their powering and are sensitive to disturbances from various light sources.

Moreover, using infrared instead of radio waves for the communication, the reading zone can be more precise and undisturbed by signal reflections. Since no radio license is needed, still another advantage is that the system can be freely sold and used all over the world.

### SUMMARY OF THE INVENTION

The invention is defined by the claims. It comprises a system with passive ID tags that are powered from, and read by, readers via infrared signals in the 700 -1100 nm band. The infrared beam is typically generated by an array of infrared light emitting diodes (LEDs).

In an embodiment, the ID tags are powered by a separate illuminator that comprises either an infrared LED array or at least one directional lamp that radiates in the 700 -1100 nm band.

Incandescent lamps, such as halogen lamps, may use a reflector to concentrate the light and thereby increase the power density of the beam so that a longer communication distance with the ID tag can be obtained. The use of a reflector also automatically reduces the glaring effects from the lamp, since the radiation strength in all directions outside the beam is reduced.

The glaring effect is however further reduced if a long-pass filter is placed in front of the lamp. The filter can hereby preferably be given a rounded shape to avoid uneven mechanical tension due to thermal expansion when the filter is heated by the attenuated part of the energizing beam.

To further minimize the heating effects and lower the cost of the filter, said filter can in a preferred embodiment be realized by a dichroic coating on glass, where the visible part of the light is reflected and the infrared part is transmitted with minimum absorption loss, so that only a fraction of the energy from the lamp is absorbed by the filter as heat. The mechanical stress is hereby significantly reduced and allows for a filter placement close to the lamp and/or an arrangement without ventilation to achieve a compact and weatherproof illuminator.

In order to maximize the life of the lamp, it can be operated at a voltage lower than nominal. Also, a light sensor or timer can be used to switch it off during daytime and/or when the surrounding light is sufficient to power the ID tag without need for energy from the lamp.

An array with solar cells connected in series provide sufficient voltage for the ID tag electronics to operate even at large distance where the illuminating power density is relatively low, provided that the solar cells are made from crystalline silicon or copper indium selenide (CIS - also called CIGS for copper indium gallium selenide). In difference to other technologies, this type of solar cells has good sensitivity in the 700 -1100 nm band.

In a special embodiment, the edges of the solar cells are passivated to avoid efficiency loss due to unwanted recombination effects that would give harmful shunting effects in the cells at large distance from the illuminator where the power density is low, typically only 1 W/sqm.

To achieve a comparatively high sensitivity in direction of the energizing light source, compared to other directions, the solar cells can in a preferred embodiment be designed with an essentially flat surface rather than with the textured type surface that usually is offered by the solar cell manufacturers. Such texture, typically realized as microsized pyramids in a regular or random pattern on the solar cell surface, makes the sun energize the solar cells over a wide angular area in order to cope with situations where the sun is not directly facing the solar cell. In a system according to the invention however, the requirement is completely opposite where transponders, and thereby the solar cells, are operated more or less face to face with the energizing source such as an array of light emitting diodes or a halogen lamp. The light hereby falls directly on to, and is absorbed by, the solar cell surface instead of bouncing off from a steep microsized pyramid slope. More energy comes to the transponder with increased reading range as the obvious result.

The illuminating- and ID tag LEDs can have different wavelength, where the former radiates at e.g. 940 nm and the other at e.g. 870 nm, minimizing disturbing leakage of infrared light from the illuminating LED array to the receiver input. This way widely available and cheap standard LEDs in e.g. gallium aluminum arsenic (GaAlAs) or GaAs technology can be used.

The ID tag typically transmits its ID codes in packets of e.g. 32 information bits and a 16 bit cyclic redundancy checksum (CRC). To save energy, the repetition interval and/or the length of each ID code can also be a function of the output voltage from the solar cells so that, at shorter distance where the power density is high, codes are sent more often and/or with more information. The system's performance and resistance to disturbances is thereby improved.

The disturbance from infrared light sources, such as fluorescent lamps, can be very different depending on the ballast that is used for the lamp. The oscillating frequency of such a disturbance signal in the 700-1100 nm region, such as from the mercury line at 1014 nm, is often modulated in the range up to 30 kHz. To further optimize the communication distance and minimize the influence of disturbance from modulated light sources, each transmitted bit therefore comprises a burst of at least two, but typically 6 - 20, infrared pulses with a pulse repetition frequency (PRF) that is at least 30 kHz while the infrared receiver has a built in filter that is tuned to the same frequency as the repetition frequency of said infrared pulses. In a preferred embodiment, both the PRF and the filter frequency are set to 455 kHz.

The precise burst length and PRF constitute a relatively complex optimum between cost, performance and interference tolerance, where higher PRF and/or more pulses per burst often increases the range and improves tolerance against disturbances at the penalty of higher cost.

The disturbance from visible (400 - 700 nm) light sources such as sunlight and incandescent lamps, as well as from fluorescent lamps, is limited by an optical pass filter in the receiver.

In addition to said filter, that is designed to suppress wavelengths other than those used for transmitting data from the ID tag, the infrared receiver can also make use of one or several lenses in close proximity with the receiver's photo detector chip, where at least one lens may have an aspherical design with an area at least four times larger than the light sensitive area of the photo detector chip. Such a lens or lens system can not only increase the effective area and reduce the spherical aberration effects but also concentrate light from ID tags inside the reading zone and suppress disturbing light originating from sources at other angles.

### DESCRIPTION OF THE DRAWING

The invention is now to be described more in detail where
Figure 1 shows a system for identification of primarily man-made objects,
Figure 2 shows an infrared receiver,
Figure 3 shows different parameters vital to the invention as a function of wavelength,
Figure 4 shows how directional light is sent out from an incandescent lamp,
Figure 5 shows how the life length of an incandescent lamp relates to the operating voltage,
Figure 6 shows how visible light is more weakened than infrared when lamp voltage is reduced,
Figure 7 shows a transponder where messages are sent out spontaneously when illuminated,
Figure 8 shows an energizing beam with short "quest" pulses and long "capture pulses",
Figure 9 shows how a transponder is to be written by short interruptions in the energizing beam,
Figure 10 shows a reader with light emitting diodes and an infrared receiver, and,
Figure 11 shows an ID tag with solar cells, a light emitting diode and a photo diode.

### PREFERRED EMBODIMENTS

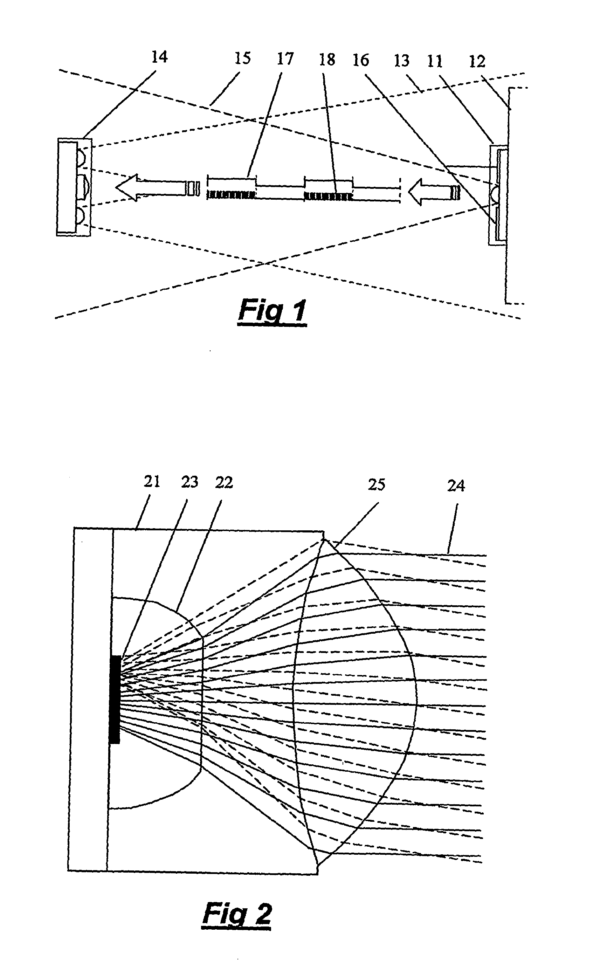

Figure 1 shows a system for identification of primarily man-made objects, where a transponder 11 at an object 12 is arranged to be energized by an essentially infrared light beam 13 at 700 - 1100 nm, and/or by visible light, and where said transponder sends messages to a reader 14 via an information beam 15 at 700-1100 nm to be received by a photovoltaic receiver in said reader, where said transponder is powered by solar cells 16 in crystalline silicon or copper indium selenide and where said messages comprise a bit stream 17 where a bit is represented by a pulse burst 18 with a pulse repetition frequency higher than 30 kHz.

A long-range identification system as described herein is often needed in applications that can not accept glaring light from the radiation source that energizes the transponders, at the same time as the installations often are subject to strong flourescent light. The invention solves the problem by using invisible infrared light to energize, as well as to read, the transponders. Reading is accomplished via an information beam from the transponder with a burst pulse repetition frequency that is substantially higher than the infrared modulated light from such fluorescent lamps. By using a receiver filter in the reader that is tuned to the pulse repetition frequency of the burst, the system can be made almost completely insensitive to such modulated infrared light. If the receiver is tuned at a relatively high frequency, such as 455 kHz commonly used for various applications in the radio industry, it is both possible to use relatively many pulses per burst for a high integration gain in the receiver and at the same time obtain a high bit rate in the infrared link to the benefit of good reading range and high reading speed.

Solar cells in crystalline silicon or copper indium selenide are characterized in that they are sensitive in the infrared region 700-1100 nm, as well as in the visible region 400 - 700 nm, at the same time as they represent commercially available low-cost technology. A transponder using such solar cells can be powered either by standard light emitting diodes at e.g. 870 nm or 940 nm, or by any incandescent or fluorescent lamps where the visible part of the spectrum has been reduced by a long-pass filter. They can of course also be powered by unfiltered light, normal daylight originating from the sun, laser radiators or any other 400 - 1100 nm light source.

Figure 2 shows how a photovoltaic receiver 21 comprises a transparent body 22 in front of a photosensitive area 23 of said receiver, where said body is designed so that visible light is attenuated in relation to light with the wavelength of an infrared information beam 24, and where said receiver furthermore includes lens 25 with an area that is substantially larger than the photosensitive area of the receiver. In a special embodiment, the lens 25 has an aspherical design.

The transparent body 22 acts as a filter and significantly reduces the sensitivity to interference from various light sources, such as the sun and man-made light sources that have strong radiation in the visible area of the spectrum.

Since a photoelectric converter chip is sensitive in a wider angular direction than what is usually needed by an identification system, a lens in front of the chip, e.g. realized by the shape of body 22, can be used to enhance light signals from a transponder in the desired field of view.

To maximize the reading range of the transponder system, it is sometimes desirable to further maximize the effective area of the receiver, in order to collect as much energy as possible from the information beam. From optical systems, such as camera lenses for photography under low light, it is known that large low-cost spherical lenses cause sharpness problems due to spherical aberration, but that such problems can be corrected by using specially designed aspherical lenses.

In a special embodiment of the receiver according to the invention, an aspherical lens 25 makes it possible to direct most of the light rays from a transponder within the field of view onto the photosensitive area of the photoelectric converter, compared to if a spherical lens is used and where a significant portion of the light rays due to spherical abberation would be directed outside the chip surface. Such an aspherical lens can preferably be manufactured in a low-cost infrared transparent polymer material, since the precision needed is not as high as in a camera lens.

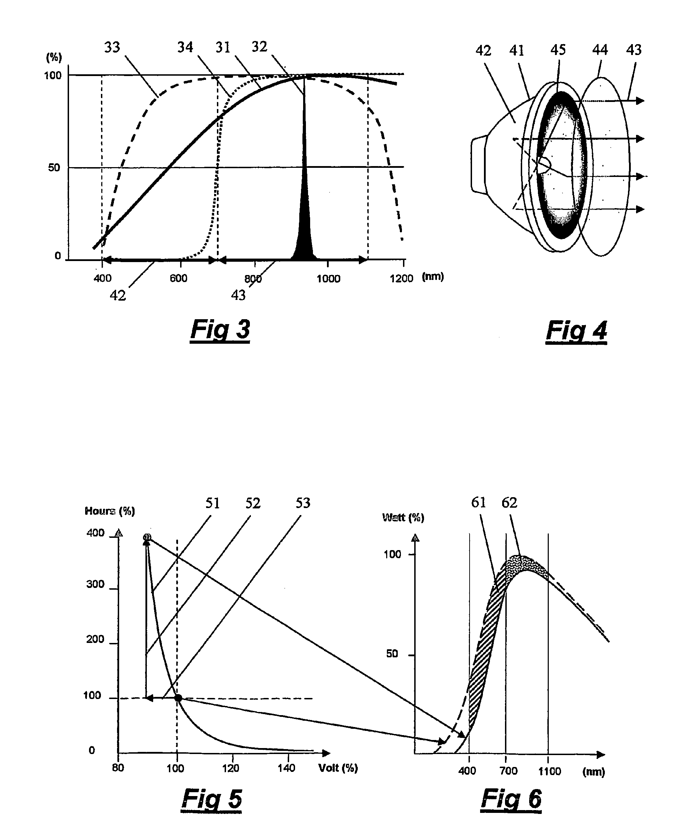

Figure 3 shows the relative radiation power 31 from an incandescent lamp for energizing said transponder as a function of wavelength, the relative radiation power 32 of a light emitting GaAlAs and/or GaAs diode, the relative efficiency 33 of a solar cell in crystalline silicon or copper indium selenide and the transmission characteristics 34 of a long-pass filter that may be of a dichroic type.

The graphs show that said light emitting diodes are well suited to activate the mentioned kinds of solar cells. It is also obvious that using a long-pass filter in front of a lamp only removes about a quarter of the energy that can be captured by the solar cell to power the transponder, and, since the range equation for a system according to the invention follows the commonly known radar equation, this means that such a long-pass filter will reduce the range with about 6 % only.

Figure 4 illustrates how directional light from an incandescent lamp 41 with an integrated reflector 42 that is reflective to infrared light at 700 -1100 nm sends out an energizing beam 43. The figure also shows how the energizing light beam from the lamp is filtered by a dichroic filter 44, where the dichroic layer or layers have been deposited on an essentially round glass substrate in front of said lamp, or directly at the front glass 45 of said lamp, so that the visible part of the spectrum of the energizing beam is attenuated in relation to light with longer wavelengths.

To obtain a long life, many lamps today use a pressurized inert gas to make it possible to increase the filament temperature without degradation of the life length of the lamp. It is also common to use a halogen gas to avoid depletion over time of material from the filament on the inside of the lamp glass thereby gradually degrading the light radiation efficiency. Said lamps often have the shape as shown in figure 4 and are commonly available with an integrated reflector that is either aluminized or dichroic, where the former also is reflective to infrared light while the latter only reflects visible light and lets infrared light pass through the reflector.

The above described lamps have low cost and are typically specified for 3000 hours of operation.

3000 hours is good, but since systems according to the invention are expected to operate continuously, reliably and without much maintenance, even longer life would be appreciated.

Figure 5 shows how the lamp's life length 51 relates to the applied voltage and the considerably increased life 52 when the lamp is operated at only moderately lower voltage 53 than nominal.

Figure 6 shows how the visible (glaring) part of the radiated power is comparatively much more weakened 61 when the voltage is reduced compared to the weakening of the infrared light 62.

Using a lamp according to the invention here described has therefore the valuable merit that it will provide an excellent life time of the energizing lamp at very low penalty in terms of reduced range. This is because, as is shown in figure 5, if the voltage of a lamp for example is reduced by 10 % to 90 % of nominal, its rated life will increase to 400 % of normal. In other words, the life length is increased from 3000 hours to 12000 hours, which is more than enough in most cases.

To avoid blackening over time in e.g. halogen lamps, it is however desirable to at regular intervals temporarily raise the value to nominal. Actually, already reducing the average voltage to 95 % of nominal voltage as prescribed by the lamp manufacturer will double the lamp life.

Moreover, reducing the voltage will shift the body of the light spectrum from visible towards infrared as is shown in figure 6. This means that the glaring effect from the lamp is significantly reduced; the light that can still be seen is not only weaker but also more red than blue and therefore more comfortable to the human eye. The improved life and the reduced glaring effects are hence achieved with very little penalty in terms of range loss, especially if the lamp has been filtered by a long-pass filter with cutoff at about 700 nm, since although the loss of 400 - 700 nm visible light power 61 is about 20 % or more, the loss of 700 - 1100 nm infrared light power is only about 10 %. Using the radar equation, this means that the range loss will only be about 3 % although the life of the lamp has been four folded. In other words; maintenance cost is reduced by 75 % at a range loss of 3 %. It should also be mentioned that the reduced energy consumption is good to the environment, since reducing the voltage by 10 % will reduce the energy consumption by approximately 20 %.

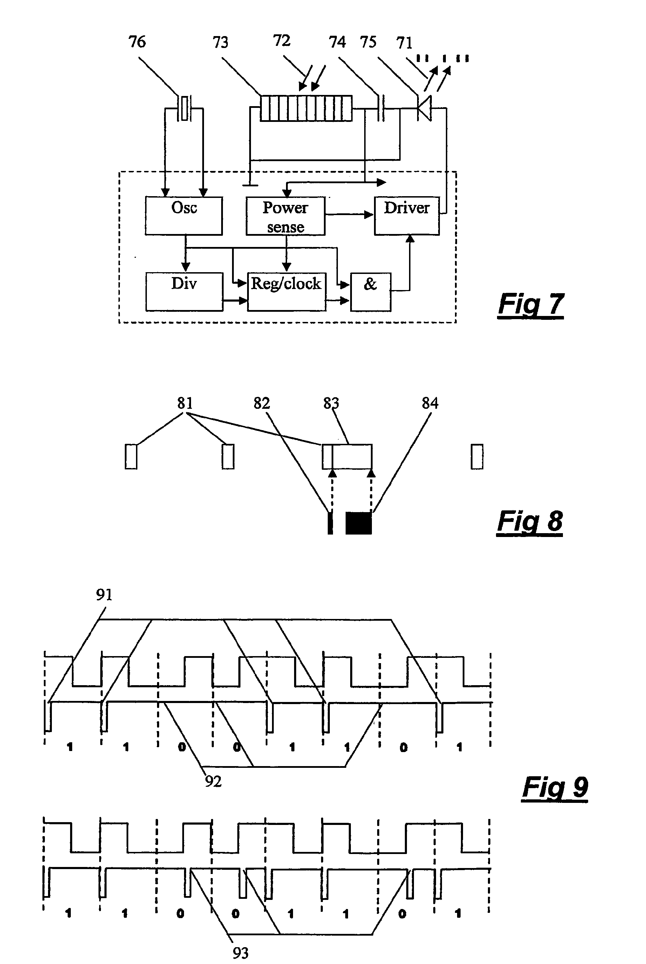

Figure 7 shows a transponder where messages 71 are sent out and spontaneously and repeatedly when it is illuminated by an un-modulated or modulated infrared energizing beam 72, and/or by surrounding light. No messages need to be sent to the transponder, which gives a simple system and a transponder that, in normal daylight, can be read even without LED or lamp energizing.

The interval between the messages can be regular for simple design, randomized for multi-tag readability, short for high passage speed or long for long reading range. The transponder is powered by a group of series-connected solar cells 73 that charge a holding capacitor 74 to a voltage that is sufficient to power the transponder electronics while it drives current through a light emitting diode 75 and sends out messages to the reader.

A piezoelectric element 76, such as a quartz crystal or a ceramic resonator, defines the frequency of a built in oscillator at e.g. 455 kHz, the frequency of which is divided to a lower frequency, such as by division with 32 to give a clocking frequency of 14.2 kHz, for clocking a shift register and/or data memory that holds the identity code of the transponder. The data output stream from the register, e.g. with a bit rate of 14.2 kbps, is then AND-gated with the oscillator clock or a signal that has been derived from said oscillator clock, to form pulse bursts, e.g. with a 16-pulse 455 kHz-burst per half-period data bit, said pulse bursts to be fed to a current driver for the light emitting diode so that an information beam with messages is sent out from the transponder.

Figure 7 also shows how the transponder is arranged to automatically adjust the transmission of said messages in relation to the power density of the light that energizes its solar cells, so that the messages under a comparatively higher power density are repeated with shorter interval between each message and/or with more information per message and/or with increased transmission peak power than if said power density is comparatively lower. These functions are accomplished with a power sense module in the transponder that is arranged to sense the voltage from the solar cells and control the timing of the register and/or the drive current in the light emitting diode.

A benefit of the adaptive transmission strength is that the system considerably improves its resistance to disturbing light, as well as to negative influence from dirt, when the range between the transponder and reader is reduced compared to at maximum distance. With the messages sent out more often, it is also possible for the system to identify safely at a higher passage speed, such as when a car enters a parking area or a parkhouse without stopping. If the messages are made longer, such as if the transponder is of the read/write type where large amounts of data may have to be read out, said adaptation at stronger light also makes such reading faster and more secure.

Figure 8 shows how the energizing beam in a first step comprises relatively short "quest" pulses 81 of high energy with a relatively long intermediate interval between these repeated quest pulses, said quest pulses however to be long enough for a transponder entering the reading zone to power up and respond with a short "present" message 82, and thereafter, in a second step upon the reader's detection of said "present" message, the transponder is interrogated by a subsequent and a relatively long "capture" high-energy pulse 83, said capture pulse to be long enough for the transponder to transmit an information message 84 such as an identity code. Although the peak energy is high in the emitted energizing pulses, the average power is low enough to be generated e.g. by standard light emitting diodes.

Using the principle shown in figure 8, it is possible to operate the light emitting diodes that are built into the reader or that are situated in an external device but that are used to power the transponder at a peak power level that may be doubled compared to the average. The invention therefore makes possible a range increase of up to about 20 % as calculated by the radar equation.

Figure 9 shows how the transponder is arranged to be written with new data by short interruptions in the energizing beam, where the average power is sufficiently high to power the transponder so that it can send messages to be received by the reader at a distance. The figure shows how these interruptions in the energizing beam are arranged so that, upon a (not shown) number of consecutive interruptions forming a synchronization sequence, a first type of digital symbol "1" (or "0") to be written to the transponder is represented by at least one interrupt 91 in the energizing beam and a second type of digital symbol "0" (or "1") is represented by an omitted interrupt 92, or by at least one interrupt 93 that has been delayed by 20 - 80 % of the bit time. The shown example is illustrated with a self-clocking coding of the data, such as Manchester coding, since a self-clocking code simplifies the synchronization of the transponder receiving and decoding circuitry with the programming bit stream from the reader.

The transponder can either detect the power interruptions by accurate sensing of the variation in the solar cell voltage due to the interrupts, or by using a separate (not shown in the figure) photosensitive converter, such as a photodiode or phototransistor, that is directly connected to the electronic circuits and memory of the transponder to write it with new data.

In a preferred embodiment, the transponder is energized by a group of light emitting diodes where the center wavelength(s) of the energizing beam is different from the wavelength of the information beam that is sent out from the transponder. The advantage with this arrangement is that direct leakage from the energizing diodes to the receiver, or via an external reflective object, has minor effect on the receiver sensitive since the receiver can be tuned only to receive at the wavelength of the information beam from the transponder.

In an embodiment where a lamp is used to generate the energizing beam, said lamp is furthermore arranged to automatically adapt its intensity to the surrounding light level. In addition to earlier mentioned life-length improving measures, adapting the intensity may further extend the life of the lamp so that it can last for five years or more without replacement.

In an embodiment with silicon solar cells in the transponder, these are designed to be of the monocrystalline type. Monocrystalline solar cells are not only slightly more efficient than multicrystalline, they are also more homogeneous from individual to individual to the benefit of transponder quality and performance predictability.

The edges of the solar cells can be passivated against low-light recombination effects that due to impurities and other defects in the material may act as a resistive shunt to the solar cell. Passivating the edges can double the efficiency at low light in a typical solar cell, corresponding to a range improvement of about 20 % as calculated by the radar equation.

The solar cell surface can also preferrably be made flat (smooth, even) and with virtually no pyramid texture so that deflection from said surface of low-light photons in a weak energizing beam is minimized. The efficiency to convert such low-level infrared light from a LED array or incandescent lamp in front of the solar cells can hereby be approximately doubled, with about 20 % range increase as a result.

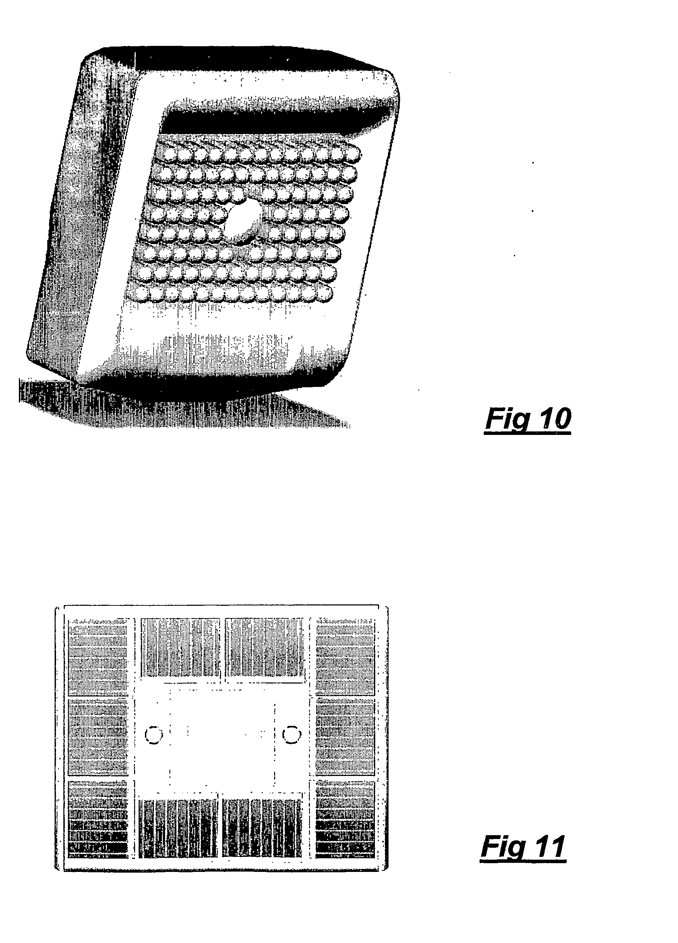

A practical implementation of the reader according to the invention is shown in figure 10, where a group of light emitting diodes are generating an invisible infrared beam to energize transponders according to the invention, and/or are used to write data to said transponders. The figure also shows an infrared receiver with a lens for efficient reception of transponder signals.

Figure 11 shows a transponder that is encased in a sturdy and weatherproof casing that is transparent to infrared signals for powering, reading and writing of data in the transponder. Ten solarcells provide power to electronic circuits that are situated in the center of the transponder, while a light emitting diode for reading, and a photosensitive diode for writing, are situated on each side of the electronic circuits.

## Claims

1. System for identification of objects (12),
which system comprises at least one reader (14) and at least one transponder (11),
where the transponder is arranged to be attached to an object,
which transponder is adapted to be energized by an essentially infrared light beam (13) at 700 - 1100 nm, and/or by visible light,
where said transponder is arranged to send messages to said reader (14) via an information beam (15) at 700 - 1100 nm,
**characterized in that**
said transponder is powered by solar cells (16) in crystalline silicon or copper indium selenide
and that said messages comprise a bit stream (17) where a bit is represented by a pulse burst (18)
where the pulse repetition frequency of the pulses in said burst, i.e. the frequency with which the pulses in each burst appears, is higher than 30kHz.

2. A system according to claim 1, **characterized in that** the reader has a photovoltaic receiver (21) for infrared light that comprises a transparent body (22) in front of the photosensitive area (23) of said receiver, where said body is designed so that visible light is attenuated in relation to light with the wavelength of said infrared information beam and where said body preferably also has a lens function.

3. A system according to claim 2, **characterized in that** said receive comprises an aspherical lens (25) with an area that is at least four times larger than the area of said photosensitive area.

4. A system according to any of claims 1 to 3, **characterized in that** the transponder is energized by directional light from an incandescent lamp (41) that contains a pressurized inert gas, and that preferably contains a halogen gas, to avoid depletion of filament material on the inside of the lamp glass, and that has an integrated reflector (42) that is reflective to infrared light at 700 - 1100 nm.

5. A system according to claim 4, **characterized in that** the visible part of the energizing light beam (43) from said lamp is reduced by an long-pass filter in front of said lamp.

6. A system according to any of claim 4 or 5, **characterized in that** a filter is provided in front of said lamp arranged to filter the energizing light beam (43) from said lamp, which filter is a long-pass filter of the dichroic type, where the dicroic layer or layers have been deposited on a glass substrate (44) in front of said lamp and/or directly at the glass (45) of said lamp so that light in the visible part of the spectrum in said beam is reduced compared to light with longer wavelengths.

7. A system according to any of claims 4 to 6, **characterized in that** the lamp is operated at a voltage that on average does not exceed 95% of the nominal voltage for said lamp.

8. A system according to any of claims 4 to 7, **characterized in that** the lamp is adapted to automatically adapt its intensity to the surrounding light level.

9. A system according to any of claims 4 to 8, **characterized in that** the glass substrate (44) has an essentially round shape.

10. A system according to any of claims 1 to 3, **characterized in that** the energizing beam is generated by at least one light emitting diode, which generated beam in a first step comprises at least one relatively short "quest" pulse (81) of high energy and a relatively long intermediate interval to the next quest pulse, said quest pulse being long enough for the transponder to power up and respond with a short "present" message (82), and thereafter, in a second step, the generated beam is arranged to interrogate said transponder by a relatively long "capture" high-energy pulse (83), said capture pulse being long enough for the transponder to transmit an information message (84) such as an identity code.

11. A system according to any of claims 1 to 3, **characterized in that** the transponder is adapted to be written with new data by short interruptions (91,93) in said energizing beam, where the average power of said energizing beam is sufficiently high to power the transponder so that it can send messages to be received by the reader at a distance.

12. A system according to claim 11, **characterized in that** said interruptions in the energizing beam are adapted such that, upon a number of consecutive interruptions forming a synchronization sequence, a first type of digital symbol "1" or "0" to be written to the transponder is represented by at least one interrupt (91) in the energizing beam and a second type of digital symbol "0" or "1" is represented by an omitted interrupt (92), or by at least one interrupt (93) that has been delayed by 20 - 80% of the bit time.

13. A system according to any of claims 1 to 12, **characterized in that** the transponder is arranged such that said messages (71) are spontaneously repeated when the transponder is illuminated by an unmodulated energizing beam (72), and/or by surrounding light.

14. A system according to any of claims 1 to 13, **characterized in that** the transponder is adapted to automatically adjust the transmission of said messages in relation to the power density of the light that energizes said solar cells, so that said messages under a comparatively higher power density are repeated with shorter interval between each message and/or with more information per message and/or with increased transmission peak power compared to if said power density is comparatively lower.

15. A system according to any of claims 1 to 14, **characterized in that** the centre wavelength(s) of the energizing beam is different from the wavelength of the information beam.

16. A system according to any of claims 1 to 15, **characterized in that** the crystalline silicon solar cells are of the monocrystalline type.

17. A system according to any of claims 1 to 16, **characterized in that** the surface of the solar cells is essentially flat and without pyramid texture so that the sensitivity to light from a direction perpendicular to said surface is improved.

18. A system according to any of claims 1 to 17, **characterized in that** the edges of the solar cells have been passivated against low-light recombination effects.

19. A system according to any of claims 1 to 18, **characterized in that** the pulse repetition frequency in said pulse burst is 455 kHz.

## Patentansprüche

1. System zur Identifikation von Objekten (12),
welches wenigstens ein Lesegerät (14) und wenigstens einen Transponder (11) umfasst,
wobei der Transponder so ausgestaltet ist, dass er an ein Objekt angebracht werden kann,
wobei der Transponder zur Anregung mit einem im wesentlichen im Infraroten liegenden Lichtstrahl (13) bei 700 - 1100 nm und/oder sichtbarem Licht geeignet ist,
wobei der Transponder so ausgestaltet ist, dass er Botschaften mittels eines Informationsstrahls (15) bei 700 - 1100 nm zu besagtem Lesegerät (14) übermitteln kann,
**dadurch gekennzeichnet,**
**dass** besagter Transponder durch Solarzellen (16) aus kristallinem Silizium oder Kupfer-Indiumselenid mit Energie versorgt wird,
und **dass** besagte Botschaft einen Bitstrom (17) umfasst, wobei ein Bit durch ein Impulsbündel (18) dargestellt wird,
wobei die Impulswiederholfrequenz der Impulse des Impulsbündels, also die Frequenz mit der die Impulse in einem jeden einzelnen Impulsbündel auftreten, höher als 30 kHz ist.

2. Ein System gemäß Anspruch 1, **dadurch gekennzeichnet, dass** das Lesegerät einen photovoltaischen Empfänger (21) für Licht im Infraroten aufweist, welcher ein transparentes Gehäuse (22) vor der Photosensitiven Fläche (23) des Empfängers aufweist, wobei das Gehäuse so gestaltet ist, dass sichtbares Licht relativ zu dem Licht des besagten Informationsstrahls mit der Wellenlänge im Infrarotbereich gedämpft wird und wobei besagtes Gehäuse bevorzugt weiterhin die Funktion einer Linse ausfüllt.

3. Ein System gemäß Anspruch 2, **dadurch gekennzeichnet, dass** besagter Empfänger eine asphärische Linse (25) umfasst mit einer Fläche, welche mindestens 4-mal größer als die Fläche der besagten Photosensitiven Fläche ist.

4. Ein System gemäß einem der Ansprüche 1 bis 3, **dadurch gekennzeichnet, dass** der Transponder angeregt wird durch gerichtetes Licht einer Glühlampe (41), welche ein Edelgas unter Druck enthält und welche bevorzugt ein Halogengas enthält, um die Abscheidung von Glühfadenmaterial auf der Innenseite des Lampenglases zu vermeiden, und welche einen integrierten Reflektor (42) besitzt, welcher Infrarote Strahlung bei 700 - 1100 nm zurückspiegelt.

5. Ein System gemäß Anspruch 4, **dadurch gekennzeichnet, dass** der sichtbare Anteil des anregenden Lichtstrahls (43) der besagten Lampe reduziert wird durch einen vor die besagte Lampe vorgeschalteten Langpassfilter.

6. Ein System gemäß einem der Ansprüche 4 oder 5, **dadurch gekennzeichnet, dass** ein vor die besagte Lampe vorgeschalteter Filter vorhanden ist, welcher so angeordnet ist, dass er den anregenden Lichtstrahl (43) aus besagter Lampe herausfiltert, wobei der Filter ein Langpassfilter vom dichromatischen Typ ist, wobei die dichromatische Schicht oder Schichten auf einem Glasssubstrat (44) abgeschieden worden sind, welches besagter Lampe vorgeschaltet ist und/oder direkt abgeschieden wurde auf dem Glas (45) der besagten Lampe, so dass der sichtbare Anteil des Lichtes aus der Lampe im Vergleich zu Licht mit längeren Wellen reduziert wird.

7. Ein System gemäß einem der Ansprüche 4 bis 6, **dadurch gekennzeichnet, dass** die Lampe bei einer Voltzahl betrieben wird, die im Durchschnitt 95 % der nominal zulässigen Voltzahl der Lampe nicht überschreitet.

8. Ein System gemäß einem der Ansprüche 4 bis 7, **dadurch gekennzeichnet, dass** die Lampe so ausgerüstet ist, dass sie automatisch ihre Intensität der Umgebungshelligkeit anpasst.

9. Ein System gemäß einem der Ansprüche 4 bis 8, **dadurch gekennzeichnet, dass** das Glassubstrat (44) eine im Wesentlichen runde Form aufweist.

10. Ein System gemäß einem der Ansprüche 1 bis 3, **dadurch gekennzeichnet, dass** der anregende Lichtstrahl durch wenigstens eine Licht-emittierende Diode erzeugt wird, wobei der erzeugte Strahl in einem ersten Schritt wenigstens einen relativ kurzen "Suchpuls" (81) mit hoher Energiedichte und einem relativ langen Zwischenintervall bis zum nächsten Suchpuls umfasst, wobei der Suchpuls lang genug ist, um den Transponder hochzufahren und mit einer kurzen "Bestätigungsbotschaft" (82) antworten zu lassen und anschließend, in einem zweiten Schritt, wird der erzeugte Strahl so moduliert, dass er den besagten Transponder mit Hilfe eines relativ langen "Erfassungspuls" mit hoher Energie (83) abfragt, wobei besagter Erfassungspuls lang genug ist, damit der Transponder eine Informationsbotschaft (84), wie zum Beispiel einen Identitätscode, übermitteln kann.

11. Ein System gemäß einem der Ansprüche 1 bis 3, **dadurch gekennzeichnet, dass** der Transponder so ausgestaltet ist, dass er beschrieben werden kann mit neuen Daten mittels kurzen Unterbrechungen (91, 93) in besagtem Anregungsstrahl, wobei die durchschnittliche Energie des Anregungsstrahls genügend hoch ist, um damit den Transponder mit Energie zu versorgen, damit er Botschaften senden kann zur Erfassung mit einem in einer Entfernung angebrachten Lesegerät.

12. Ein System gemäß Anspruch 11, **dadurch gekennzeichnet, dass** besagte Unterbrechungen in besagtem Anregungsstrahl so ausgestaltet sind, dass bei Vorliegen ein Anzahl an eine Synchronisationssequenz bildenden, aufeinander folgenden Unterbrechungen, eine erste Ausführung eines digitalen Symbols "1" oder "0", welches auf den Transponder geschrieben werden soll, dargestellt werden kann durch wenigstens eine Unterbrechung (91) in dem Anregungsstrahl und eine zweite Ausführung eines digitalen Symbols "1" oder "0" dargestellt wird durch eine ausgelassene Unterbrechung (92), oder durch wenigstens eine Unterbrechung (93), welche um 20 - 80 % der Bitzeit verzögert wird.

13. Ein System gemäß einem der Ansprüche 1 bis 12, **dadurch gekennzeichnet, dass** der Transponder so ausgestaltet ist, dass besagte Botschaften (71) spontan wiederholt werden, wenn der Transponder durch einen unmodulierten Anregungsstrahl (72) beleuchtet wird, und/oder durch Umgebungslicht.

14. Ein System gemäß einem der Ansprüche 1 bis 13, **dadurch gekennzeichnet, dass** der Transponder so ausgestaltet ist, dass er die Übertragung der besagten Botschaften automatisch anpassen kann unter Berücksichtigung der Stromdichte des Lichtes, welches die besagten Solarzellen mit Energie versorgt, so dass die Botschaften bei relativ hoher Stromdichte des Lichtes mit kürzeren Intervallen zwischen den einzelnen Botschaften und/oder mit mehr Information pro Botschaft und/oder mit höherer Spitzenstromstärke der Übertragung übertragen werden, verglichen zu dem Zustand in dem besagte Stromdichte vergleichsweise niedriger ist.

15. Ein System gemäß einem der Ansprüche 1 bis 14, **dadurch gekennzeichnet, dass** die Mittenwellenlänge(n) des Anregungsstrahles verschieden von der Wellenlänge des Informationsstrahls ist.

16. Ein System gemäß einem der Ansprüche 1 bis 15, **dadurch gekennzeichnet, dass** das die Solarzellen mit kristallinem Silizium vom monokristallinen Typ sind.

17. Ein System gemäß einem der Ansprüche 1 bis 16, **dadurch gekennzeichnet, dass** die Oberfläche der Solarzellen im Wesentlichen flach ist und ohne pyramidale Textur, um so die Lichtempfindlichkeit für Licht aus der Lotrechten zu verbessern.

18. Ein System gemäß einem der Ansprüche 1 bis 17, **dadurch gekennzeichnet, dass** die Kanten der Solarzellen gegen Schwachlichtrekombinationseffekte passiviert worden sind.

19. Ein System gemäß einem der Ansprüche 1 bis 18, **dadurch gekennzeichnet, dass** die Wiederholfrequenz der Pulse in besagtem Pulsbündel 455 kHz beträgt.

## Revendications

1. Système d'identification d'objet (12) comprenant
au moins un lecteur (14) et au moins un transpondeur (11),
le transpondeur est prévu pour être fixé à un objet,
le transpondeur est adapté pour être alimenté principalement par un faisceau de lumière infrarouge (13) à une longueur d'onde de 700 nm à 1100 nm et/ ou par de la lumière visible, et
le transpondeur est destiné à envoyer des messages vers le lecteur (14) par l'intermédiaire d'un faisceau d'information (15) d'une longueur d'onde de 700 nm à 1100 nm,
**caractérisé en ce que**
le transpondeur est alimenté par des cellules solaires (16) de silicium cristallin ou de séléniure de cuivre-indium, et
les messages comprennent un flux de bits (17) avec un bit représenté par une salve d'impulsions (18),
la fréquence de répétition des impulsions dans la salve, c'est-à-dire la fréquence selon laquelle les impulsions apparaissent dans chaque salve étant supérieure à 30 kHz.

2. Système selon la revendication 1,
**caractérisé en ce que**
le lecteur est un récepteur photovoltaïque (21) pour de la lumière infrarouge qui comporte un corps transparent (22) devant une zone photosensible (23) du récepteur, ce corps étant conçu pour atténuer la lumière visible en liaison avec la lumière de la longueur d'onde du faisceau d'information à lumière infrarouge et le corps a, de préférence, également une fonction de lentille.

3. Système selon la revendication 2,
**caractérisé en ce que**
le récepteur comporte une lentille sphérique (25) ayant une surface qui est au moins quatre fois supérieure à la surface de la zone photosensible.

4. Système selon l'une quelconque des revendications 1 à 3,
**caractérisé en ce que**
le transpondeur est alimenté par la lumière directionnelle d'une lampe à incandescence (41) contenant un gaz inerte et, de préférence, un gaz halogène pour éviter l'appauvrissement du matériau du filament à l'intérieur de l'ampoule de verre, et
un réflecteur intégré (42) réfléchit la lumière infrarouge d'une longueur d'onde comprise dans une plage de 700 nm à 1100 nm.

5. Système selon la revendication 4,
**caractérisé en ce que**
la partie visible du faisceau de lumière d'alimentation (43) émis par la lampe est réduite par un filtre passe-long en amont de la lampe.

6. Système selon l'une des revendications 4 ou 5,
**caractérisé en ce que**
le filtre est prévu devant la lampe pour filtrer le faisceau de lumière d'alimentation (43) émis par la lampe, le filtre étant un filtre passe-long de type dichroïque, la couche dichroïque ou les couches dichroïques ayant été déposées sur un substrat en verre (44) devant la lampe et/ou directement sur le verre (45) de la lampe de façon à réduire la lumière visible dans le spectre du faisceau par comparaison à une lumière ayant des longueurs d'onde plus grandes.

7. Système selon l'une quelconque des revendications 4 à 6,
**caractérisé en ce que**
la lampe fonctionne sous une tension qui, en moyenne, ne dépasse pas 95% de la tension nominale de la lampe.

8. Système selon l'une quelconque des revendications 4 à 7,
**caractérisé en ce que**
la lampe s'adapte automatiquement en intensité au niveau lumineux ambiant.

9. Système selon l'une quelconque des revendications 4 à 8,
**caractérisé en ce que**
le substrat de verre (44) a principalement une forme ronde.

10. Système selon l'une quelconque des revendications 1 à 3,
**caractérisé en ce que**
le faisceau d'alimentation est généré par au moins une diode photoémissive, le faisceau généré dans une première étape comportant au moins une impulsion de « requête » (81) relativement courte, de niveau d'énergie élevé et un intervalle intermédiaire relativement long par rapport à l'impulsion de « requête » suivante, l'impulsion de « requête » étant suffisamment longue pour permettre au transpondeur de s'alimenter et de répondre par un bref message « présent » (82) puis, au cours d'une seconde étape, le faisceau généré interroge le transpondeur par une impulsion de forte énergie (83) de « capture », relativement longue, l'impulsion de capture étant suffisamment longue pour que le transpondeur puisse transmettre un message d'information (84) tel qu'un code d'identification.

11. Système selon l'une quelconque des revendications 1 à 3,
**caractérisé en ce que**
le transpondeur peut recevoir l'inscription de nouvelles données par de brèves interruptions (91, 93) dans le faisceau d'alimentation, la puissance moyenne du faisceau d'alimentation étant suffisamment élevée pour alimenter le transpondeur qui pourra envoyer des messages que doit recevoir le lecteur à distance.

12. Système selon la revendication 11,
**caractérisé en ce que**
les interruptions du faisceau d'alimentation sont adaptées de façon qu'après un nombre d'interruptions consécutives formant une séquence de synchronisation, un premier type de symboles numériques « 1 » ou « 0 » à inscrire dans le transpondeur soit représenté par au moins une interruption (91) du faisceau d'alimentation et qu'un second type de symboles numériques « 0 » ou « 1 » soit représenté par l'omission d'une interruption (92) ou par au moins une interruption (93) qui, en réalité, est retardée de 20 % à 80 % de la durée d'un bit.

13. Système selon l'une quelconque des revendications 1 à 12,
**caractérisé en ce que**
le transpondeur est conçu pour que les messages (71) soient répétés spontanément si le transpondeur est éclairé par un faisceau d'alimentation (72) non modulé et/ou par la lumière ambiante.

14. Système selon l'une quelconque des revendications 1 à 13,
**caractérisé en ce que**
le transpondeur est conçu pour régler automatiquement la transmission des messages en liaison avec la densité de puissance de la lumière qui alimente les cellules solaires de façon que des messages soient répétés sous une densité de puissance relativement élevée avec un intervalle court entre chaque message et/ou avec plus d'informations par message et/ou avec une puissance maximale de transmission augmentée par comparaison au cas où la densité de puissance serait comparativement plus faible.

15. Système selon l'une quelconque des revendications 1 à 14,
**caractérisé en ce que**
la longueur d'onde centrale du faisceau d'alimentation est différente de la longueur d'onde du faisceau d'informations.

16. Système selon l'une quelconque des revendications 1 à 15,
**caractérisé en ce que**
les cellules solaires sont à silicium cristallin de type monocristallin.

17. Système selon l'une quelconque des revendications 1 à 16,
**caractérisé en ce que**
la surface des cellules solaires est essentiellement plate ou sans texture pyramidale pour améliorer la sensibilité à la lumière dans une direction perpendiculaire à cette surface.

18. Système selon l'une quelconque des revendications 1 à 17,
**caractérisé en ce que**
les bords des cellules solaires ont été passivés contre les effets de recombinaison sous une lumière faible.

19. Système selon l'une quelconque des revendications 1 à 18,
**caractérisé en ce que**
la fréquence de répétition des impulsions dans la salve d'impulsions est de 450 kHz.
